# EUROPEAN PATENT SPECIFICATION

(11) **EP 0 581 426 B1**
(45) Date of publication and mention of the grant of the patent: **16.08.2000**
(21) Application number: 93304439.8
(22) Date of filing: 08.06.1993
(51) Int. Cl.: G01R 15/08

(54) **Autoranging instrument having selectable range setting restrictions**
Instrument mit automatischer Bereichswahl mit einstellbaren Auswahlbeschränkungen
Instrument à sélection automatique de gamme avec des restrictions de sélection variables

(30) Priority: 30.07.1992 US 922282
(43) Date of publication of application: 02.02.1994
(73) Proprietor: JOHN FLUKE MFG. CO., INC., Everett Washington 98206 (US)
(72) Inventor: Gibson, Robert T., Snohomish, WA 98290 (US)
(74) Representative: Burke, Steven David

(56) References cited:
- EP-A- 0 504 514
- US-A- 3 697 960
- FUNKSCHAU, no.5, March 1984, MUNCHEN DE pages 49 - 50 E.SCHOLZ 'Ziffern und Balken'
- FUNKSCHAU, no.25, December 1981, MUNCHEN DE pages 75 - 76 R.MAJOR 'Multimeter mit Mikroprozessor'
- ELEKTOR ELECTRONICS, vol.13, no.146, June 1987, CANTERBURY GB pages 51 - 53 'Autoranging Digital Multimeter'
- SIEMENS POWER ENGINEERING V, no.6, 1983, BERLIN DE pages 304 - 305 W.WEHRMANN ET AL. 'MULTIZET Analog Multimeters'
- TOUTE L'ELECTRONIQUE, no.488, November 1983, PARIS FR pages 38 - 46 E.CATIER 'Les multimètres numériques'

## Description

### Background of the Invention

The present invention relates generally to electronic test tools, and more particularly, to autoranging instruments that automatically select an appropriate scale for the electric parameter being measured.

Technicians testing and repairing electrical equipment often need to measure a variety of electric parameters whose values may vary significantly. For example, a piece of equipment or system under test may have voltages present that range from millivolts to tens or even hundreds of volts. In these situations, the instrument of choice is typically a digital multimeter having multiple scales, or ranges, that permits the technician to measure these voltages using just one instrument. Available to the technician, are digital multimeters whose range settings must be selected manually, "autoranging" digital multimeters that automatically select range settings and meters with both manual and autoranging features. As applied herein, the terms "scale" and "range" are considered synonymous and, therefore, are used interchangeably.

Manual range selection may be preferable over autoranging in applications where absolute speed is important (since most meters operate faster in the manual mode) or where the user knows that all measurements will be in one particular range. However, in situations where parameter values vary widely, autoranging meters are generally preferred because they don't require the technician to waste time manually selecting the proper range. Accordingly, in certain applications, autoranging instruments can improve the user's efficiency and overall performance.

Autoranging instruments in the prior art usually uprange or downrange to the lowest possible range setting that will permit a full scale readout on the display and, thereby, provide the greatest possible display resolution. There are situations, however, where a high degree of resolution is not only unnecessary, but also undesirable, because it may make the readout difficult to interpret and, thereby, lead to confusion.

In applications where technicians are making "go/no go" tests, they may be only interested in approximate values of the parameters being measured. For example, a technician testing an automobile's electrical system may only be interested in whether the voltage at a particular test point is within the range called for in the maintenance manual, such as 10-12 volts for example. If, the voltage at the test point was low, say only 1-2 volts, the technician would know the system was out of spec, without knowing (or caring) that the actual voltage was, for example, 1.050 volts. However, a typical prior art autoranging instrument would sense the low voltage and downrange to provide greater resolution and display the actual voltage (1.050 volts). Not expecting the range change, the technician might misread the display as 10.50 volts, causing him or her to mistakenly believe the system is within the 10-12 volt range required by the spec. Thus, as stated above and illustrated by way of this example, the autoranging feature of prior art meters may, in certain applications, be undesirable.

Elektor Electronics, vol. 13, no. 146, pages 51 to 53, describes an autoranging meter in which the instrument, when measuring DC voltage, automatically selects the most appropriate one of four ranges to ensure optimum accuracy of the readout. When measuring resistance or current, there are also four ranges; however the user operates a mode switch which, in one position, allows the instrument automatically to select between the two upper ranges, and in the other position allows the instrument automatically to select between the two lower ranges. Accordingly, this forces the user into manually switching to an appropriate mode, and if the selected mode is inappropriate the measurement can be displayed with the wrong resolution, as in the arrangements described above.

Funkschau, no. 5/1984, pages 49 and 50, describes an autoranging meter in which the actual range can be locked, thereby disabling the autoranging.

Accordingly, there is a need for an autoranging instrument that is easy to use and does not present unnecessary and unwanted resolution, especially when the instrument is in the autorange mode.

### Summary of the Invention

Aspects of the present invention are set out in the accompanying claims.

An autoranging instrument according to a preferred embodiment has a plurality of measurement range settings and includes circuitry for acquiring and converting measured values into digital data for interpretation and storage by a controller such as a microprocessor, and a display for providing a digital readout of the measured values. The instrument is operable in an autoranging mode whereby the controller automatically selects an appropriate one of the plurality of measurement range settings based on the value of the parameter being measured. A function selector is coupled to the controller and provides range limit information that causes the controller to limit the measurement range settings that may be selected in the autoranging mode.

Preferably, the range limit information is a range floor that establishes the minimum measurement range setting to which the instrument may be set in the autorange mode.

Preferably, the function selector is a pushbutton operable to select different range floors and to increment the selected range floor through the plurality of measurement range settings.

A method in accordance with the present invention preferably includes the steps of determining an uprange value and a downrange value as a function of the measurement range setting, upranging the instrument to a higher measurement range setting if the value of the parameter to be measured is above the uprange value, and downranging the instrument to a lower measurement range setting if the value of the parameter to be measured is less than the downrange value and if the lower measurement range setting is not below a selected range floor.

### Brief Description of the Drawings

An arrangement embodying the invention will be described with reference to the accompanying drawings, wherein:
FIG. 1 is a perspective view of a handheld digital multimeter according to the present invention;
FIG. 2 is a simplified block diagram illustrating important elements of the digital multimeter depicted in FIG 1;
FIG. 3 is a flow chart illustrating broad functional steps of a resolution limiting process according to the present invention;
FIG. 4 is flow chart illustrating in greater detail the select new range floor step depicted in FIG. 3;
FIG. 5 is flow chart illustrating in greater detail the uprange present range setting step depicted in FIG. 3;
FIG. 6 is flow chart illustrating in greater detail the downrange present range setting step depicted in FIG. 3; and
FIG. 7 is a flow diagram illustrating the range selection sequence during the select new range floor, uprange and downrange steps of FIG. 3.

### Description of the Preferred Embodiment

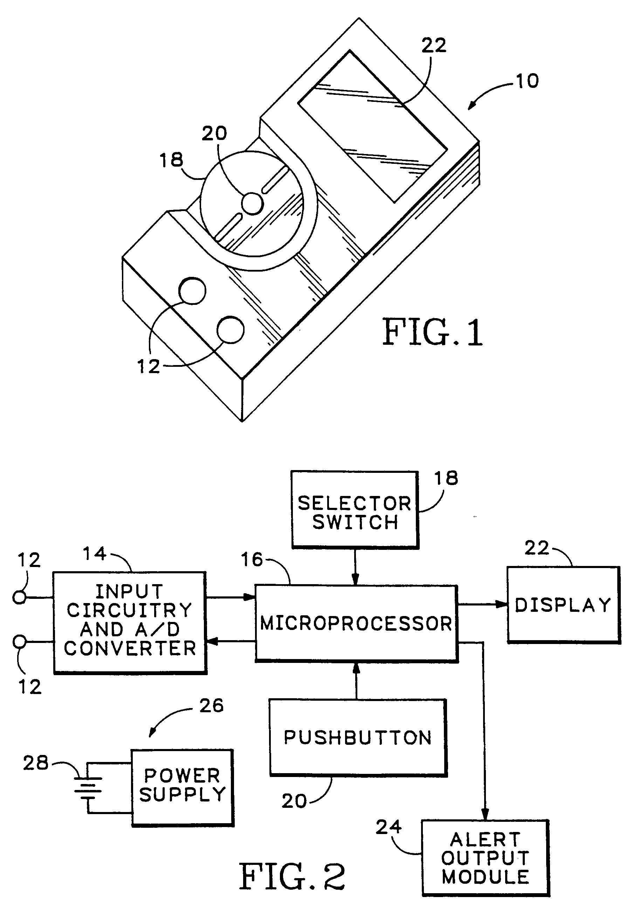

Referring now to FIG. 1, illustrating a perspective view of a handheld digital multimeter in accordance with the present invention, multimeter 10 is provided with input connectors 12 extending to the top face of the meter case and which connect to test leads (not illustrated) for coupling the meter to a device under test. Disposed along one edge of the top face of the meter is a function selector 18 comprising, for example, a rotary selector switch, which serves to allow the meter operator to choose various meter functions. A second function selector 20 comprising, for example, a pushbutton, is centrally located on function selector 18 and, like function selector 18, allows the meter operator to choose various meter functions. Further located on the front face of the meter case on the side of function selectors 18 and 20 opposite from input connectors 12 is display 22, suitably comprising a liquid crystal display. In addition to display 22, multimeter 10 also includes alert output module 24 (not shown in FIG.1) for providing additional feedback to the user.

Referring next to FIG. 2, illustrating a simplified block diagram of a preferred embodiment of multimeter 10 of FIG. 1, input connectors 12 are coupled to input circuitry and A/D converter 14 that generates a digital representation of the analog signal presented at input connectors 12. Controller 16, comprising for example a microprocessor, is coupled to receive the digital output of input circuitry and A/D converter 14 for processing. Controller 16 also receives input from selector switch 18 as well as from pushbutton 20, operative to control various functions of multimeter 10. Controller 16 supplies data to alert output module 24 for generating an alert signal during operation that may comprise an audible tone. Controller 16 also provides data to input circuitry and A/D converter 14 so as to permit proper configuration for the measurement being made. Controller 16 further supplies display data to display 22 in order to provide visual information, such as a readout of measurement values. Power supply 26, including battery 28 coupled thereto, supplies power to the various circuits of multimeter 10.

In operation, multimeter 10 performs measurements on a programmed, cyclical basis, periodically sampling signals at the input and converting them from analog to digital form for processing and display. One function of pushbutton 20 is to place multimeter 10 in an automatic range selection mode (hereinafter "autorange mode"), in which the controller automatically selects an appropriate range, or scale, corresponding to the value of the signal appearing at input connectors 12. As noted above, controller 16 provides data to properly configure input circuitry and A/D converter 14. This data includes range information that scales input circuitry and A/D converter 14 and permits the analog signal to be properly converted to a digital representation. Display 22 also receives range information from controller 16, which causes the display to present the readout of a measured value in the appropriate form, which includes the appropriate scale. The following example further illustrates the autorange mode.

Assume for purposes of this example, that multimeter 10 has the following measurement range settings for reading DC voltage: 1000V, 400V, 40V, 4V, 4000mV and 400mV, and that display 22 is a four digit display whose readout of a measured value always consists of four digits irrespective of the decimal point location. Also, for this example, assume meter 10 behaves like prior art meters, in that range floor information is not provided. Once multimeter 10 is placed in the autorange mode (preferably by default or by pressing pushbutton 20), the meter automatically selects an appropriate measurement range setting for input circuitry and A/D converter 14 and display 22. In this example, a 900 volt signal causes the instrument to select the 1000 volt range and display the readout as "0900 V", while a 300 volt signal causes controller 16 to select the 400V range setting a display readout of "300.0 V". If the next measured value is three (3) volts, the controller causes the instrument to downrange to the 4V range and produce a display readout of "3.000 V". Similarly, a 300 millivolt signal will cause the instrument to select the 400mV range and display the readout as "300.0 mV". As is apparent from this example, it is possible for a technician to misread the display and overlook the "m" icon and mistake a reading of 300 millivolts for 300 volts.

As will become better understood from the following discussion, the present invention allows a technician to select a range floor and, thereby, avoid the confusion illustrated in the above example. In accordance with the preferred embodiment of the present invention and in keeping with the above example, the technician presses button 20 to select, for example, a 400 volt range floor. A 900 volt signal still causes the instrument to uprange to the 1000 volt measurement range setting and display the reading as "0900V" and a 300 volt signal would still be displayed as "300.0 V". However, because of the 400 volt range floor, a three (3) volt value would be displayed as "003.0 V" and a 300 millivolt signal would now be displayed as "000.3 V". Thus, in accordance with the present invention, the meter would uprange, up to and including the highest measurement range setting available to the meter, but would downrange only as far as the selected range floor. As a result, the maximum display resolution is limited to the resolution available at the selected range floor, thereby minimizing the number of different display readouts presented to the user and reducing the possibility of confusion in reading the displayed readouts.

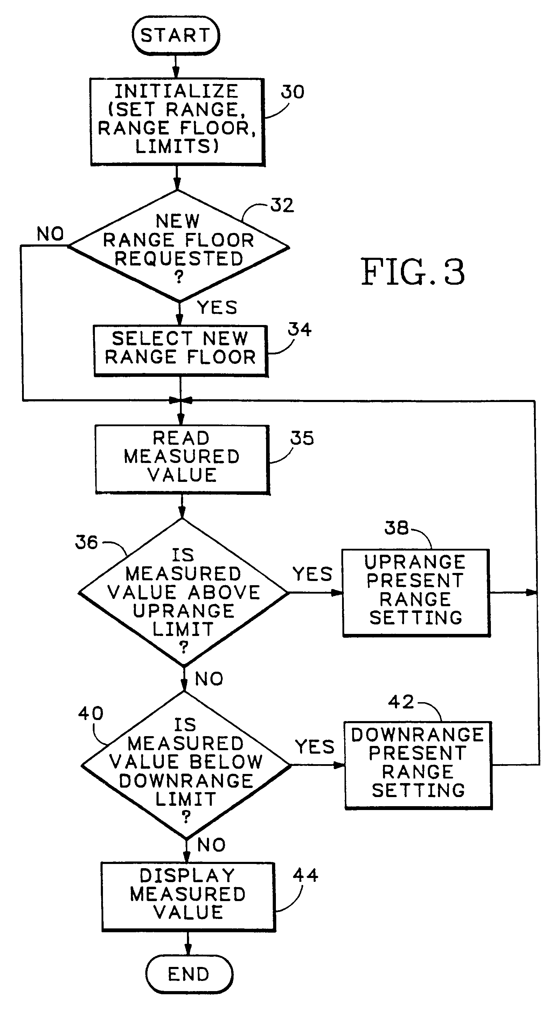

Referring now to FIG. 3, there is illustrated broad functional steps of a resolution limiting process performed by controller 16, which begins when the multimeter is turned on and placed in the autorange mode and proceeds to block 30, initialize range, range floor and limits. During the initialize step, the measurement range setting and range floor are set to default values, and uprange and downrange limits are set. The limits are preferably set as some percentage of the measurement range setting. For example, the uprange and downrange limits may be set to 95 and 5 percent of the present (in this case, default) measurement range setting, respectively.

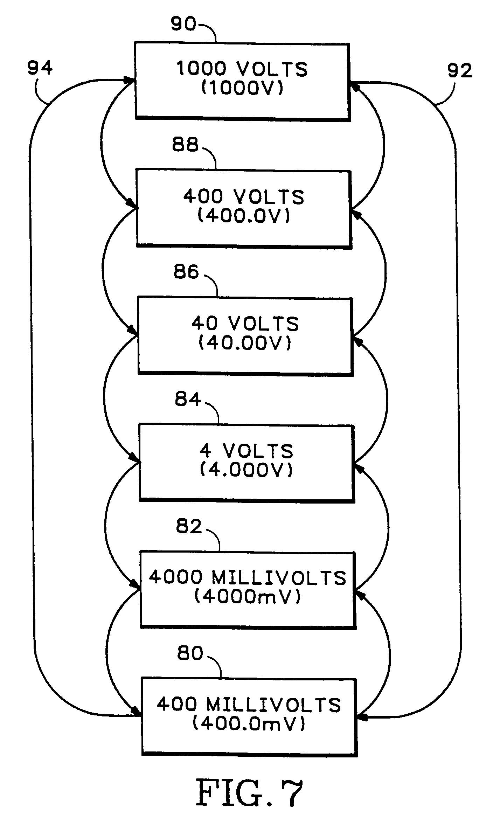

After initializing, the process proceeds to decision block 32 to determine if a new range floor has been requested. If a new range floor has not been requested, the process continues to decision block 36 described below. If, however, the user has called for a new range floor (by operating button 20) the process proceeds to block 34, select new range floor. A new range floor is preferably selected through a progression of steps through all of the measurement range settings available to the multimeter. This process is illustrated in FIG. 7, a flow diagram of the range selection process, in which path 92 represents the preferred sequence of range floor selections. The ranges depicted in FIG. 7 are consistent with the above example and are considered illustrative, not exclusive, of the present invention.

In accordance with the preferred embodiment of applicants' invention, the range floor is incremented one range each time the operator presses button 20. As an illustration, if the default range floor is the 40 volt range, and the operator presses button 20 once, controller 16 causes the meter to increment the range floor one range to the 400 volt range setting. Similarly, if the button is depressed three times, the controller causes the range to increment two ranges to the top range (1000 V) and then wrap around to the 400 millivolt range as illustrated by path 92 of FIG. 7.

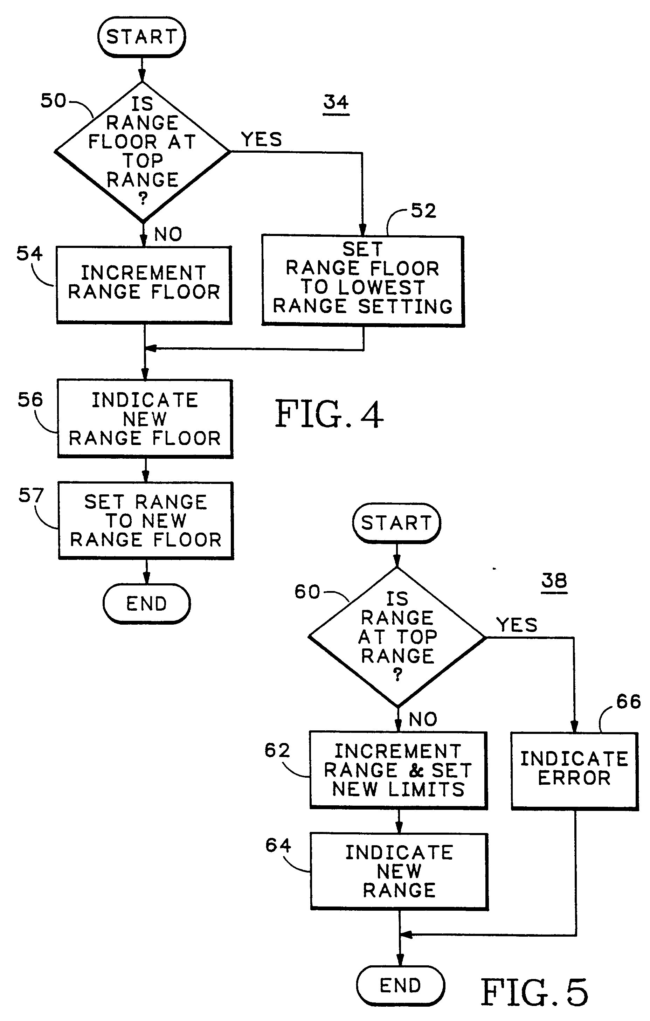

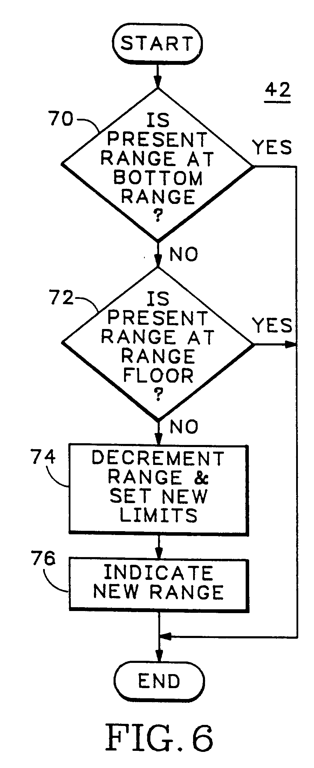

Once a new range floor is selected, the process continues to block 35, read measured value, to take a reading of the analog signal appearing at input connectors 12 (i.e., the measured value). Once a reading of the measured value has been taken, the process proceeds to decision block 36 to determine whether the measured value is above the uprange limit, that is, whether the value of the parameter being measured is above the previously set uprange limit. If yes, the process proceeds to block 38 and upranges the present measurement range setting of the meter as shown by path 92 of FIG. 7, and then returns to block 35. Block 38 is illustrated in greater detail in FIG. 5 and is discussed more fully below. If the measured value is not above the uprange limit, the process continues to decision block 40 to determine whether the measured value is below the downrange limit. If no, the process continues to block 44 and displays the measured value. If, however, the measured value is below the downrange limit, the process proceeds to block 42 and downranges the present range setting of the meter as further shown by path 94 in FIG. 7, and then returns to block 35. Block 42 is illustrated in greater detail in FIG. 6 and is discussed below. Once the measured value is displayed the resolution limiting process ends for the present reading.

Turning now to FIG. 4, there is illustrated various steps in block 34 of FIG. 3 for selecting a new range floor. Once the technician has called for a new range floor by pressing button 20, the process of FIG. 3 enters decision block 50 to determine whether the range floor is at the top range. If yes, that is, if the range floor is already at the highest measurement range setting of the instrument, such as 1000 volts in the above example, then the process proceeds to block 52 and sets the range floor to the lowest range setting (e.g., 400 millivolts). As discussed above, this wrap around effect is illustrated by path 92 in FIG. 7. Once the range floor has been set to the lowest range setting, the process proceeds to block 56 and indicates the new range floor. If, on the other the hand, the range floor is not at the top range setting, the process continues to block 54 and increments the range floor to the next measurement range setting as further illustrated in FIG. 7. Next the process proceeds to block 56 and indicates the new range floor. From block 56, the process proceeds to block 57, set range to new range floor, wherein the measurement range setting is set to the new range floor indicated in block 56 and, thereafter, the process ends.

Referring next to FIG. 5, there is illustrated various steps of block 38 of FIG. 3, uprange present range setting of the meter. If the measured value is above the uprange limit, the process of Fig. 3 enters decision block 60 to determine if the range is at the top measurement range setting of the meter. If yes, that is, if the present range setting is already set to the top range of the meter, the process proceeds to block 66, indicate error, and causes an error signal, such as "overload" to be displayed and, thereafter ends. If the present measurement range setting is not already at the top range, the process continues to block 62, increment range as depicted by path 92 in FIG. 7. During this step the process also sets new range limits, that is new uprange and downrange limits based on the value of the new measurement range setting. The process next continues to block 64, indicate new range and, thereafter, ends.

Turning to FIG. 6, there is depicted various steps in block 42 of FIG. 3, downrange present range setting of the meter. If the measured value is below the downrange limit, the process enters decision block 70 to determine if the present range is at the bottom range of the meter. If yes, the process ends. If the present range is not already at the bottom measurement range setting of the meter, the process proceeds to decision block 72 to determine if the present range is at the range floor. If yes, that is if the present range setting of the meter is the same as the present range floor, the process ends. In other words, the process will not decrement the meter range setting below the selected range floor. As noted previously, limiting the downranging to the range floor effectively limits the resolution of the measured value on display 22, thereby reducing the possibility of the operator misreading the displayed value. If the present range is not at the range floor, the process continues to block 74, decrement range and set new limits, which is further illustrated by path 94 in FIG. 7. Next the process proceeds to block 76, indicate new range (i.e., new measurement range setting) and, thereafter, ends.

Referring to FIG. 7, briefly discussed above, six (6) different measurement range settings are illustrated by blocks 80-90. In keeping with the above example, range settings of 400mV, 4000mV, 4V, 40V, 400V, and 1000V correspond to blocks 80-90, respectively. Each block includes a parenthetical expression illustrating a representative readout of display 22 corresponding to the particular measurement range setting.

While a preferred embodiment of the present invention has been illustrated and generally and by way of example, it will be appreciated that various changes can be made therein without departing from the scope of the claims. For example, the logic of range selection could be reversed from that illustrated in FIG. 7 and the range floor could be selected as a range "ceiling". Furthermore, the function selectors, namely selector switch 18 and pushbutton 20, could exist in any form of user interface, such as slide switches, key pad, or even through voice recognition. Consequently, the invention can be practiced otherwise than as specifically described herein.

## Claims

1. An autoranging instrument operable in a first, autoranging mode to provide an indication of a measured value of a signal using a range setting which has been automatically selected from a plurality of possible settings (80 to 90) in response to the signal being measured, characterised by means (20) permitting a user to switch the instrument from the first mode to a range limit mode in which automatic selection from some of said settings can still take place, but selection of at least one of said plurality of settings (80 to 90) is inhibited.

2. An instrument as claimed in claim 1, in which selection of at least the lowest range setting (80) is inhibited in the range limit mode.

3. An instrument according to claim 1 or 2, comprising:
(a) circuitry (14) for acquiring and converting the measured value of the signal into digital data;
(b) a controller (16) coupled to receive said digital data for automatically selecting an appropriate one of the plurality of measurement range settings (80 to 90) based on the measured value of said signal;
(c) user-operable range limiting means (20) for selectively providing range limit information that causes the controller (16) to limit the measurement range settings that may be selected; and
(d) a display (22) for providing a readout of said measured value.

4. An instrument as claimed in any preceding claim, arranged such that the user can choose between a plurality of range limit modes in which different ones of said settings (80 to 90) are inhibited.

5. A method of limiting display resolution in an autoranging instrument having a plurality of measurement range settings available in an autorange mode, the method comprising the steps of:
(a) reading the value of an electric signal to be measured;
(b) selecting, in the autorange mode, one of a said plurality of measurement range settings (80 to 90); and
(c) displaying a readout of the measured value according to the selected setting;
characterised by the step of:
(d) manually selecting a range limit and in response thereto providing range limit information for limiting the measurement range settings that may be selected in the autorange mode, the selected range setting being compatible with the range limit information and the value of the parameter to be measured.

## Patentansprüche

1. Instrument mit automatischer Bereichswahl, das in einer ersten, automatisch bereichswählenden Betriebsart zur Bereitstellung einer Anzeige eines gemessenen Werts eines Signals unter Verwendung einer Bereichseinstellung betreibbar ist, die als Reaktion auf das gemessene Signal aus einer Vielzahl von möglichen Einstellungen (80 bis 90) automatisch ausgewählt worden ist,
**gekennzeichnet durch**
eine Einrichtung (20), die einem Anwender ermöglicht, das Instrument von der ersten Betriebsart in eine Bereichsbegrenzungsbetriebsart zu schalten, bei der noch eine automatische Auswahl von einigen der Einstellungen erfolgen kann, wobei aber eine Auswahl zumindest einer Einstellung aus der Vielzahl der Einstellungen (80 bis 90) gesperrt ist.

2. Instrument nach Anspruch 1, bei dem in der Bereichsbegrenzungsbetriebsart die Auswahl zumindest der niedrigsten Bereichseinstellung (80) gesperrt ist.

3. Instrument nach Anspruch 1 oder 2, mit
(a) einer Schaltung (14) zur Erlangung und Wandlung des gemessenen Werts des Signals in digitale Daten,
(b) einer angeschlossenen Steuereinrichtung (16) zum Empfang der digitalen Daten für eine automatische Auswahl einer geeigneten Meßbereichseinstellung aus der Vielzahl der Meßbereichseinstellungen (80 - 90) auf der Grundlage des gemessenen Werts des Signals,
(c) einer anwenderseitig betreibbaren Begrenzungseinrichtung (20) zur wahlweisen Bereitstellung einer Bereichsbegrenzungsinformation, die die Steuereinrichtung (16) zur Begrenzung der auswählbaren Meßbereichseinstellungen veranlaßt, und
(d) einer Anzeigeeinrichtung (22) zur Bereitstellung einer Sichtanzeige des gemessenen Werts.

4. Instrument nach einem der vorstehenden Ansprüche, derart eingerichtet, daß der Anwender zwischen einer Vielzahl von Bereichsbegrenzungsbetriebsarten wählen kann, bei denen verschiedene Einstellungen aus den Einstellungen (80 bis 90) gesperrt sind.

5. Verfahren zum Begrenzen einer Anzeigeauflösung bei einem automatisch bereichswählenden Instrument mit einer Vielzahl von Meßbereichseinstellungen, die in einer automatisch bereichswählenden Betriebsart verfügbar sind, wobei das Verfahren die Schritte aufweist
(a) Lesen des Werts eines zu messenden elektrischen Signals,
(b) Auswählen einer Meßbereichseinstellung aus der Vielzahl der Meßbereichseinstellungen (80 bis 90) in der automatisch bereichswählenden Betriebsart, und
(c) Anzeigen einer Sichtanzeige des gemessenen Werts gemäß der ausgewählten Einstellung,
**gekennzeichnet durch** den Schritt
(d) manuelles Auswählen einer Bereichsbegrenzung und als Reaktion darauf Bereitstellen einer Bereichsbegrenzungsinformation zur Begrenzung der Meßbereichseinstellungen, die in der automatisch bereichswählenden Betriebsart ausgewählt werden können, wobei die ausgewählte Bereichseinstellung mit der Bereichsbegrenzungsinformation und dem Wert des zu messenden Parameters vereinbar ist.

## Revendications

1. Instrument à sélection automatique de gamme susceptible de fonctionner dans un premier mode de sélection automatique de gamme afin de produire une indication d'une valeur mesurée d'un signal utilisant un paramètre de gamme qui a été automatiquement sélectionné à partir d'une multiplicité de paramètres possibles (80 à 90) en réponse au signal mesuré, caractérisé par un moyen (20) permettant à un utilisateur de commuter l'instrument du premier mode à un mode de limite de gamme dans lequel la sélection automatique à partir d'un desdits paramètres peut encore avoir lieu, mais la sélection d'au moins un desdits paramètres de ladite multiplicité des paramètres (80 à 90) est inhibée.

2. Instrument selon la revendication 1, dans lequel la sélection d'au moins le paramètre de gamme le plus faible (80) est inhibée dans le mode de limite de gamme.

3. Instrument selon la revendication 1 ou 2, comprenant:
(a) un ensemble de circuits (14) destinés à acquérir et convertir la valeur mesurée du signal en données numériques ;
(b) un contrôleur (16) relié afin de recevoir lesdites données numériques afin de sélectionner automatiquement un paramètre approprié de la multiplicité de paramètres de gamme de mesure (80 à 90) en fonction de la valeur mesurée dudit signal ;
(c) un moyen de limitation de gamme à configuration par l'utilisateur (20) destiné à produire de manière sélective des informations de limite de gamme permettant la limitation par le contrôleur (16) des paramètres de gamme de mesure qui ont été sélectionnés ; et
(d) un afficheur (22) destiné à produire une valeur de lecture de ladite valeur mesurée.

4. Instrument selon l'une quelconque des revendications précédentes, disposé de telle sorte que l'utilisateur puisse choisir entre une multiplicité de modes de limite de gamme dans lesquels différents paramètres de ladite multiplicité de paramètres (80 à 90) sont inhibés.

5. Procédé de limitation de la résolution d'affichage dans un instrument à sélection automatique de gamme ayant une multiplicité de paramètres de gamme de mesure offerte dans un mode de sélection automatique de mode, le procédé comprenant les étapes consistant à ;
(a) lire la valeur d'un signal électrique à mesurer ;
(b) sélectionner, dans le mode de sélection automatique de gamme, un des paramètres de ladite multiplicité de paramètres de gamme de mesure (80 à 90) ; et
(c) afficher une lecture de la valeur mesurée en fonction du paramètre sélectionné ;
caractérisée par l'étape consistant à :
(d) sélectionner manuellement une limite de gamme et, en réponse à cela, produire des informations de limite de gamme destinées à limiter les paramètres de gamme de mesure susceptibles d'être sélectionnés dans le mode de sélection automatique de mode, le paramètre de gamme sélectionné étant compatible avec les informations de limite de gamme et la valeur du paramètre à mesurer.
